# EUROPÄISCHE PATENTANMELDUNG

(11) **EP 4 020 809 A1**
(43) Veröffentlichungstag der Anmeldung: **29.06.2022**
(21) Anmeldenummer: 21216962.7
(22) Anmeldetag: 22.12.2021
(51) Int. Cl.: H03K 17/975, E05B 81/76

(54) **ELEKTRONISCHES SENSORMODUL, GRIFFMODUL UND BEWEGLICHES FAHRZEUGELEMENT**

(30) Priorität: 22.12.2020 DE 102020216511
(71) Anmelder: Witte Automotive GmbH, 42551 Velbert (DE)
(72) Erfinder: MENSCH, Reinaldo, 42113 Wuppertal (DE); ZAMMERT, Christian, 42389 Wuppertal (DE); HERDERING, Markus, 44866 Bochum (DE)
(74) Vertreter: Liedtke & Partner Patentanwälte

(57) **Zusammenfassung**

Die Erfindung betrifft ein elektronisches Sensormodul (10), insbesondere für einen Griff, umfassend zumindest:
- eine Sensoreinheit (110) mit
einem beweglichen Sensorelement (117) und
einem festen Sensorelement (116), welches beabstandet und gegenüberliegend zu dem beweglichen Sensorelement (117) angeordnet ist, und

- eine Elektronikeinheit (109), die elektrisch mit den Sensorelementen (116, 117) zum Auslösen eines Schaltsignals verbunden ist und auf der das feste Sensorelement (116) angeordnet ist, wobei zumindest das bewegliche Sensorelement (117) mittels eines Schaummaterials (11) zumindest bereichsweise gekapselt ist und als ein integriertes Bauteil (103) in Form einer Vormontageeinheit (27) ausgebildet ist, wobei Anschlusselemente (12) des beweglichen Sensorelements (117) aus dem Schaummaterial (11) in einem Vormontagezustand herausragen und in einem montierten Zustand mit der Elektronikeinheit (109) verbunden sind. Des Weiteren betrifft die Erfindung ein Griffmodul (100) und ein bewegliches Fahrzeugelement (201).

## Beschreibung

Die Erfindung betrifft ein elektronisches Sensormodul und ein Griffmodul, insbesondere für einen Griff, wie zum Beispiel einen Außengriff, zum Beispiel für ein bewegliches Fahrzeugelement, wie eine Schiebetür, eine Heckklappe oder eine Motor-/Fronthaube, eines Fahrzeugs. Des Weiteren betrifft die Erfindung ein bewegliches Fahrzeugelement mit einem solchen Griffmodul und einem solchen Sensormodul.

Griffmodule sind beispielsweise bekannt an Fahrzeugtüren, Heckklappen oder Motorhauben. Diese sind üblicherweise mit einem Griffelement versehen, das nach außen geschwenkt werden kann, um die Fahrzeugtür, die Heckklappe oder die Motorhaube öffnen zu können. Griffmodule können dabei elektronische Sensormodule zum Öffnen eines Schlosses der Tür umfassen.

Der Erfindung liegt die Aufgabe zu Grunde, ein gegenüber dem Stand der Technik verbessertes Sensormodul anzugeben, welches kompakt aufgebaut ist und eine vereinfachte Montage ermöglicht. Des Weiteren ist ein Griffmodul mit einem solchen verbesserten Sensormodul und ein bewegliches Fahrzeugelement mit einem solchen Griffmodul anzugeben.

Die Aufgabe wird hinsichtlich des elektronischen Sensormoduls erfindungsgemäß mit den im Patentanspruch 1 angegebenen Merkmalen gelöst. Hinsichtlich des Griffmoduls wird die Aufgabe erfindungsgemäß durch die im Patentanspruch 8 angegebenen Merkmale gelöst. Hinsichtlich des beweglichen Fahrzeugelements wird die Aufgabe erfindungsgemäß durch die im Patentanspruch 14 angegebenen Merkmale gelöst.

Weiterbildungen der Erfindung sind Gegenstand der abhängigen Patentansprüche.

Das erfindungsgemäße elektronische Sensormodul, insbesondere für einen Griff, wie zum Beispiel einen Türgriff, umfasst zumindest eine Sensoreinheit mit einem beweglichen Sensorelement und einem festen Sensorelement, welches beabstandet und gegenüberliegend zu dem beweglichen Sensorelement angeordnet ist, und eine Elektronikeinheit, die elektrisch mit den Sensorelementen zum Auslösen eines Schaltsignals verbunden ist und auf der das feste Sensorelement angeordnet ist, wobei zumindest das bewegliche Sensorelement mittels eines Schaummaterials zumindest bereichsweise gekapselt ist und als ein integriertes Bauteil in Form einer Vormontageeinheit ausgebildet ist, wobei Anschlusselemente des beweglichen Sensorelements aus dem Schaummaterial in einem Vormontagezustand herausragen und in einem montierten Zustand mit der Elektronikeinheit verbunden sind.

Mit anderen Worten: Zumindest das bewegliche Sensorelement und optional das feste Sensorelement sind mittels des Schaummaterials gekapselt und bilden das gekapselte und integrierte Bauteil in Form der Vormontageeinheit, die in einem Vormontagezustand auf der Elektronikeinheit montierbar ist.

Zusätzlich kann das Sensormodul, insbesondere deren elektronische Komponenten, wie zum Beispiel die Sensoreinheit und eine integrierte Schaltungsanordnung, zumindest bereichsweise von einem Vergussmaterial umgeben und als eine integrierte Baueinheit, insbesondere als eine separate Montageeinheit oder ein separates Montagemodul, ausgebildet sein. Dabei ist die Vormontageeinheit mit dem an der Elektronikeinheit montierten beweglichen Sensorelement und dem optionalen festen Sensorelement Teil der integrierten Baueinheit und damit Teil der separaten Montageeinheit des Sensormoduls.

Das bewegliche Sensorelement ist mittels des Schaummaterials derart bereichsweise gekapselt, dass es vor äußeren Umwelteinflüssen, wie Feuchtigkeit, Regen, Schmutzwasser, geschützt ist. Somit sind das bewegliche Sensorelement und optional das feste Sensorelement in der Vormontageeinheit mittels des Schaummaterials gekapselt und geschützt angeordnet. Zudem ist als Schaummaterial ein solches elastisches Material vorgesehen, dass das bewegliche Sensorelement zusätzlich elastisch gelagert ist. Dabei kann das Schaummaterial gleichzeitig eine Verbindungs-, Rückstell- und Abdichtungsfunktion ausüben. Beispielsweise für die Verbindungsfunktion kann das bewegliche Sensorelement mittels des Schaummaterials mit der Elektronikeinheit verbunden sein. Darüber hinaus kann das Schaummaterial für eine Rückstellfunktion derart ausgebildet sein und das bewegliche Sensorelement derart kapseln, dass dieses nach Beendigung einer Auslösebewegung selbsttätig in eine Ausgangs- oder Ruhestellung zurückgestellt wird.

Die mit der Erfindung erzielten Vorteile bestehen insbesondere darin, dass das bewegliche Sensorelement der Sensoreinheit mittels des Schaummaterials im Sensormodul beweglich gelagert ist, wobei das Schaummaterial eine Verbindungs-, Rückstell- und Abdichtungsfunktion übernimmt. Darüber hinaus ist zumindest das bewegliche Sensorelement und optional das feste Sensorelement als integrierte Baueinheit und Vormontageeinheit vor äußeren Umwelteinflüssen, wie Feuchtigkeit, Regen, Schmutzwasser, geschützt. Eine solche Teilkapselung der Sensoreinheit und Ausbildung als Vormontageeinheit ermöglicht eine separate Herstellung und Lieferung sowie eine einfache Montage.

Im montierten Zustand der Vormontageeinheit mit der Elektronikeinheit kann darüber hinaus das elektronische Sensormodul als eine Montageeinheit ausgebildet sein. Hierdurch ist das elektronische Sensormodul als separate Montageeinheit variabel an oder in einem Griffmodul montierbar.

In einer Weiterbildung ist das bewegliche Sensorelement als ein elastisches Auslöseelement ausgebildet. Dies ermöglicht in einfacher Art und Weise einen manuell kraftgesteuerten Druckschalter mit Rückstellfunktion. Zusätzlich kann das bewegliche Sensorelement als ein elektronisches Sensorelement, insbesondere eine kapazitive Sensorelektrode, geschaltet werden. Hierdurch kann das bewegliche Sensorelement zusätzlich zur Erkennung einer Annäherung eines Objekts verwendet werden und somit als Annäherungssensor dienen.

Eine mögliche Ausführungsform sieht vor, dass das bewegliche Sensorelement ein Basiselement umfasst, das vollständig oder bereichsweise von dem Schaummaterial gekapselt ist. Das Basiselement bildet dabei ein elastisches Auslöseelement, welches zumindest in Richtung des festen Sensorelements mit dem Schaummaterial versehen ist. Beispielsweise ist das Basiselement als eine Auslöseplatte, insbesondere eine Blattfeder, ein Federblech oder eine Blechplatte, ausgebildet. Die Anschlusselemente des beweglichen Sensorelements sind vorzugsweise als Oberflächenanschlusselemente (= sogenannte SMD-Anschlusselemente) ausgebildet.

Zusätzlich kann die Sensoreinheit von einem Vergussmaterial zumindest bereichsweise umgeben sein. Hierdurch ist die Sensoreinheit selbst gegenüber äußeren Einflüssen, wie Feuchtigkeit, mechanischen Beanspruchungen, Schmutz, Wasser, Regen, geschützt.

In einer möglichen Ausführungsform ist die Sensoreinheit als ein Kraftsensor, insbesondere ein kraftgesteuerter kapazitiver oder induktiver Sensor, zum Ausführen einer Schaltfunktion, wie zum Beispiel zum Entriegeln eines Türschlosses und Öffnen einer Tür, ausgebildet.

Dazu ist zusätzlich ein Betätigungselement vorgesehen, das oberhalb und/oder unterhalb des elastischen Auslöseelements angeordnet ist. Das Betätigungselement kann bereichsweise oder vollständig von dem Schaummaterial gekapselt und Teil des integrierten Bauteils und der Vormontageeinheit sein. Beispielsweise kann das Betätigungselement bei einer Anordnung unterhalb des beweglichen Sensorelements Teil des integrierten Bauteils sein. Bei einer Anordnung oberhalb des beweglichen Sensorelements kann dieses in einem Abstand zu dem beweglichen Sensorelement angeordnet sein. In einer weiteren Alternative kann das oberhalb des beweglichen Sensorelements angeordnete Betätigungselement direkt auf dem beweglichen Sensorelement angeordnet sein und vom Schaummaterial umgeben sein und somit ein Teil des integrierten Bauteils bilden.

Das Griffmodul, insbesondere ein Außengriffmodul für ein bewegliches Fahrzeugelement, insbesondere eine Tür eines Fahrzeugs, umfasst erfindungsgemäß zumindest das zuvor beschriebene elektronische Sensormodul und einen Griffträger, an oder in welchem das elektronische Sensormodul anordbar, insbesondere montierbar, oder angeordnet ist.

Die mit der Erfindung erzielten Vorteile bestehen insbesondere darin, dass das elektronische Sensormodul als Ganzes in dem Griffmodul verbaut, insbesondere als eine separate integrierte Baueinheit und Montageeinheit vormontiert und dann im Griffmodul endmontiert, werden kann. Dabei ist die Vormontageeinheit mit zumindest dem gekapselten beweglichen Sensorelement und dem optionalen gekapselten festen Sensorelement und/oder dem optionalen gekapselten Betätigungselement Teil der Montageeinheit. Bei einer Ausbildung des elektronischen Sensormoduls als eine Montageeinheit entfallen aufwendige einzelne Montageschritte, wie sie aus dem Stand der Technik bekannt sind. Darüber hinaus sind durch die Ausbildung des Griffmoduls mit einem innen liegenden Sensormodul mit gekapselten elektronischen Komponenten diese geschützt angeordnet. Zusätzlich kann das Sensormodul mittels einer Vergussmasse gekapselt und somit vor äußeren Einflüssen geschützt werden.

In einer möglichen Ausführungsform ist das elektronische Sensormodul als eine Auslöseeinheit zum automatischen Auslösen einer Funktion, insbesondere zum Auslösen einer Entriegelung und eines automatischen Öffnens eines Türschlosses der Tür ausgebildet. Durch die Integration von Elektronikeinheit und Sensoreinheit in das elektronische Sensormodul und damit in die Auslöseeinheit kann das Sensormodul zusätzlich zur Auslösefunktion weitere Funktionen, zum Beispiel weitere elektronische Griff-, Schloss- und/oder Türfunktionen, übernehmen und ausführen.

Bei einer Anordnung eines Betätigungselements oberhalb eines beweglichen Sensorelements im Sensormodul können dabei der Griffträger und das Betätigungselement die Auslöseeinheit zusätzlich kapselnd umgeben.

Durch die Ausbildung des Sensormoduls als integrierte Baueinheit im Griffmodul und die zusätzliche Kapselung des Sensormoduls durch den Griffträger und das Betätigungselement ist eine zusätzliche Dichtebene auf der Außenseite des Griffmoduls gegeben, so dass der Betätigungs-, insbesondere ein Hubmechanismus, des Betätigungselements ebenfalls abgedichtet ist.

Eine mögliche Ausführungsform sieht vor, dass das integrierte Bauteil des Sensormoduls im Griffträger an einer Innenseite des Griffträgers im Bereich einer Durchgangsöffnung und gegenüberliegend zum Betätigungselement angeordnet und montiert ist. Dies ermöglicht einen kompakten Aufbau des Griffmoduls und kleine Betätigungshübe.

In einer weiteren Ausführungsform umfasst die Elektronikeinheit eine Leiterplatte mit einer ersten Oberflächenseite und einer zweiten Oberflächenseite. Auf der ersten Oberflächenseite ist eine integrierte Schaltungsanordnung, zum Beispiel eine Multi-Funktionselektronik für ein oder mehrere Funktionen, insbesondere für ein oder mehrere elektronische Griff-, Schloss- und/oder Türfunktionen, angeordnet. Auf der gegenüberliegenden zweiten Oberflächenseite ist die Sensoreinheit angeordnet.

Eine Weiterbildung sieht vor, dass die Sensoreinheit als ein Kraftsensor, insbesondere ein kraftgesteuerter kapazitiver oder induktiver Sensor, zum Entriegeln und Öffnen des Schlosses und des beweglichen Fahrzeugelements ausgebildet ist. Insbesondere ist die Sensoreinheit als ein sogenanntes MOC-Modul ausgebildet (= metall-over-cap-Modul), bei welchem die innen liegenden metallischen Sensorelemente nach außen hin gekapselt sind.

Beispielsweise umfasst die Sensoreinheit ein Sensorgehäuse, das bewegliche Sensorelement und das feste Sensorelement. Das feste Sensorelement kann beispielsweise direkt auf der zweiten Oberflächenseite der Leiterplatte angeordnet sein. Das bewegliche Sensorelement, insbesondere ein Auslöseelement, kann in einer Aufnahmeöffnung des Sensorgehäuses angeordnet sein. Dabei ist das bewegliche Sensorelement insbesondere in einem Abstand zum festen Sensorelement angeordnet. Das Sensorgehäuse und das bewegliche Sensorelement kapseln dabei das innen liegende feste Sensorelement nach außen hin ab. Das Sensorgehäuse ist insbesondere ein Kunststoffgehäuse und kann an die Leiterplatte angeformt, insbesondere angespritzt sein. Das Sensorgehäuse kann als ein 2-Komponenten-Gehäuse ausgebildet sein. Beispielsweise kann das Sensorgehäuse eine innen liegende weiche Gehäusewand und eine diese umgebende äußere harte Gehäusewand aufweisen. Das Sensorgehäuse dient als Abdichtung gegen Feuchtigkeit und Verschmutzung des Inneren der Sensoreinheit.

Im eingebauten Zustand des elektronischen Sensormoduls im Griffmodul ist das bewegliche Sensorelement, insbesondere das Auslöseelement, im Bereich der Durchgangsöffnung derart angeordnet, dass es die Durchgangsöffnung von innen zumindest teilweise überdeckt. Darüber hinaus ist das Betätigungselement derart im Bereich der Durchgangsöffnung angeordnet, dass es die Durchgangsöffnung von außen zumindest teilweise überdeckt. Insbesondere ragt das Betätigungselement derart in die Durchgangsöffnung zumindest bereichsweise hinein, dass es in einer unbetätigten Stellung zum beweglichen Sensorelement, zum Beispiel dem Auslöseelement, beabstandet angeordnet ist. Dies ermöglicht einen kompakten Aufbau des Griffmoduls und kleine Betätigungshübe. Darüber hinaus sind die Betätigungskräfte einstellbar, insbesondere sind Schwellenwerte vorgebbar.

Eine weitere Ausführungsform sieht vor, dass das Betätigungselement ein Druckübertragungselement umfasst, das nach innen in Richtung der Sensoreinheit ragt. Beispielsweise umfasst das Betätigungselement einen nach innen ragenden Druckstift, zum Beispiel einen Bolzen oder Pin, welcher zur Betätigung des beweglichen Sensorelements in Druckrichtung bewegbar ist. Insbesondere ist das Betätigungselement derart betätigbar, dass es in Druckrichtung durch die Durchgangsöffnung hindurch bis zum beweglichen Sensorelement, einem Auslöseelement zum Beispiel, bewegbar ist und dieses bei weiterer Druckbetätigung in Richtung des festen Sensorelements bewegt. Hierdurch wird der Abstand zwischen beweglichen Sensorelement, zum Beispiel einem Auslöseelement, und dem festen Sensorelement reduziert, so dass sich ein zwischen diesen vorhandenes Messfeld ändert. Das bewegliche Sensorelement ist hierzu beispielsweise als eine Federplatte oder ein Federblech ausgebildet.

Des Weiteren kann das Betätigungselement eine einer äußeren Betätigungsfläche gegenüberliegende Innenseite aufweisen, die mittels eines Verbindungselements mit dem Griffträger zumindest im Bereich der Durchgangsöffnung abdichtend verbunden ist. Dabei kann das Verbindungselement zusätzlich als ein Rückstellelement ausgebildet sein, das bei einer Betätigung des Betätigungselements von einer unbetätigten Position in eine betätigte Position dieses bei Nichtbetätigung zurück in die unbetätigte Position stellt. Beispielsweise ist das Verbindungselement als ein Kunststoffstrang, insbesondere ein Gummi- oder Schaumstrang, ausgebildet. Das Verbindungselement kann auf der der Sensoreinheit zugewandten Seite des Betätigungselements einen im Randbereich der Durchgangsöffnung angeordneten umlaufenden Dichtungsstrang bilden. Alternativ oder zusätzlich kann das Verbindungselement das Betätigungselement auf der der Sensoreinheit zugewandten Seite randseitig umlaufen und gegen Feuchtigkeit und Verschmutzung abdichten. Hierzu ist das Verbindungselement aus einem Weichkomponentenmaterial, insbesondere aus einem Schaum-, Kunststoff- oder Gummimaterial gebildet.

Darüber hinaus betrifft die Erfindung ein bewegliches Fahrzeugelement, das zumindest ein Griffmodul, wie oben beschrieben, umfasst, in welchem ein elektronisches Sensormodul, wie oben beschrieben, anordbar oder angeordnet ist. Bei dem beweglichen Fahrzeugelement kann es sich um ein manuell zu öffnendes oder elektrisch zu öffnendes, insbesondere aufzuschwenkendes oder aufzuschiebendes, Element, wie eine Fahrzeugtür, eine Schiebetür, eine Front- oder Motorhaube, eine Heccklappe eines Fahrzeugs handeln.

Ausführungsbeispiele der Erfindung werden anhand von Zeichnungen näher erläutert. Dabei zeigen:
- Figur 1: in Explosionsdarstellung eine erste Ausführungsform eines elektronischen Sensormoduls,
- Figur 2: im zusammengesetzten Zustand die erste Ausführungsform des Sensormoduls gemäß Figur 1,
- Figur 3: in Explosionsdarstellung eine zweite Ausführungsform eines Sensormoduls,
- Figur 4: im zusammengesetzten Zustand die zweite Ausführungsform des Sensormoduls gemäß Figur 3,
- Figur 5: in Explosionsdarstellung eine dritte Ausführungsform eines Sensormoduls,
- Figur 6: im zusammengesetzten Zustand eine vierte Ausführungsform eines Sensormoduls,
- Figur 7: im zusammengesetzten Zustand eine fünfte Ausführungsform eines Sensormoduls,
- Figur 8: im zusammengesetzten Zustand eine sechste Ausführungsform eines Sensormoduls,
- Figur 9: in perspektivischer Darstellung ein Sensormodul als Montageeinheit,
- Figur 10: schematisch eine Schnittdarstellung eines Griffmoduls mit einem elektronischen Sensormodul,
- Figur 11: schematisch in Draufsicht ein Griffmodul,
- Figur 12: schematisch in Seitenansicht ein Fahrzeug mit einem beweglichen Fahrzeugelement, welches ein Griffmodul zur Entriegelung eines Türschlosses umfasst,
- Figur 13: schematisch in perspektivischer Teilansicht das Griffmodul mit einem Sensormodul als integrierte Baueinheit,
- Figur 14: schematisch in Explosionsdarstellung das Griffmodul mit einem Sensormodul als integrierte Baueinheit,
- Figur 15: schematisch eine Oberseite der integrierten Baueinheit für das Griffmodul,
- Figur 16: schematisch eine Unterseite der integrierten Baueinheit für das Griffmodul, und
- Figur 17: schematisch in Blockdarstellung Komponenten einer Elektronikeinheit des Sensormoduls.

Einander entsprechende Teile sind in allen Figuren mit den gleichen Bezugszeichen versehen.

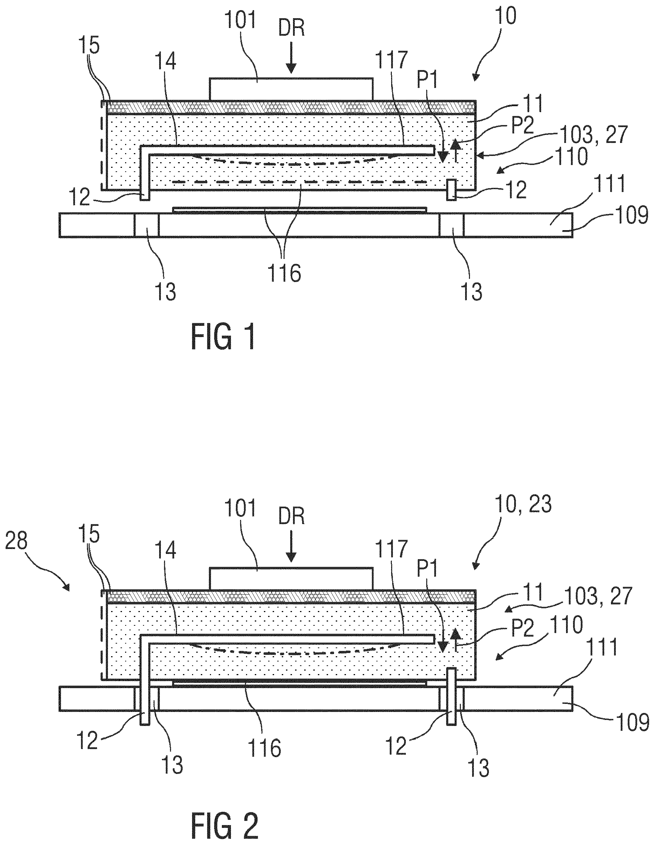

**Figur 1** zeigt schematisch in Explosionsdarstellung eine mögliche Ausführungsform für ein elektronisches Sensormodul 10. **Figur 2** zeigt das elektronische Sensormodul 10 in zusammengebauter Fassung.

Das elektronische Sensormodul 10 umfasst zumindest eine Elektronikeinheit 109 und eine Sensoreinheit 110 mit einem festen Sensorelement 116 und einem beweglichen Sensorelement 117.

Das feste Sensorelement 116 ist beabstandet und gegenüberliegend zu dem beweglichen Sensorelement 117 angeordnet. Die Elektronikeinheit 109 ist mit den Sensorelementen 116, 117 zum Auslösen eines Schaltsignals verbunden. Die Elektronikeinheit 109 umfasst beispielsweise eine Leiterplatte 111.

Das feste Sensorelement 116 ist dabei beispielsweise als eine Metallschicht, insbesondere eine Kupferschicht, auf der Leiterplatte 111 ausgebildet.

Darüber hinaus ist das bewegliche Sensorelement 117 mittels eines Schaummaterials 11 zumindest bereichsweise gekapselt und als ein integriertes Bauteil 103 in Form einer Vormontageeinheit 27 ausgebildet. Das integrierte Bauteil 103 ist als Vormontageeinheit 27 auf der Leiterplatte 111 montierbar. In einem Vormontagezustand, wie in **Figur 1** gezeigt, ragen Anschlusselemente 12 aus dem Schaummaterial 11 und der Vormontageeinheit 27 heraus. Im montierten Zustand, dargestellt in **Figur 2****,** sind die Anschlusselemente 12 mit der Elektronikeinheit 109 verbunden, insbesondere elektrisch und mechanisch verbunden und bilden die integrierte Baueinheit 23 des elektronischen Sensormoduls 10.

Wie in **Figur 1** anhand der gestrichelten Darstellung des festen Sensorelements 116 gezeigt, kann optional das feste Sensorelement 116 ebenfalls vom Schaummaterial 11 gekapselt sein.

Zum Anschließen des beweglichen Sensorelements 117 an die Elektronikeinheit 109 umfasst das bewegliche Sensorelement 117 die Anschlusselemente 12, die aus dem Schaummaterial 11 herausragen und mit der Elektronikeinheit 109 zu verbinden sind (**Figur 1****,** Vormontagezustand) oder verbunden, zum Beispiel gelötet, sind (**Figur 2****,** montierter Zustand). Im montierten Zustand der Vormontageeinheit 27 mit der Leiterplatte 111 bilden diese zusammen die integrierte Baueinheit 23 des Sensormoduls 10. Diese integrierte Baueinheit 23 wiederum kann als eine separate Montageeinheit 28 ausgebildet sein.

**Figuren 1 und 2** zeigen als Anschlusselemente 12 Steckkontaktierungen. Hierzu sind die Anschlusselemente 12 als vertikale elektrische Steckverbindungen ausgebildet, die durch Durchgangsöffnungen 13 der Leiterplatte 111 hindurch gesteckt werden und welche dann mit der Leiterplatte 111 auf der gegenüberliegenden Seite mit einer Leiterbahn oder einem Anschlusskontakt verbunden, insbesondere verlötet werden.

Das bewegliche Sensorelement 117, zum Beispiel ein Federelement, wie eine Blattfeder, oder ein Metallblech, ist mittels des Schaummaterials 11 derart bereichsweise gekapselt, dass es vor äußeren Umwelteinflüssen, wie Feuchtigkeit, Regen, Schmutzwasser, geschützt ist. Zumindest das bewegliche Sensorelement 117 ist vom Schaummaterial 11 umgeben und bildet mit diesem zusammen das integrierte Bauteil 103. Die Anschlusselemente 12 ragen somit auch aus dem integrierten Bauteil 103 heraus.

Zudem ist als Schaummaterial 11 ein solches elastisches Material vorgesehen, dass das bewegliche Sensorelement 117 zusätzlich elastisch gelagert ist.

Dabei kann das Schaummaterial 11 gleichzeitig eine Verbindungs-, Rückstell- und Abdichtungsfunktion ausüben. Für die Verbindungsfunktion kann das bewegliche Sensorelement 117 optional mittels des Schaummaterials 11 mit der Elektronikeinheit 109, insbesondere der Leiterplatte 111, verbunden sein. Darüber hinaus kann das Schaummaterial 11 für eine Rückstellfunktion derart ausgebildet sein und das bewegliche Sensorelement 117 derart kapseln, dass dieses nach Beendigung einer Auslösebewegung selbsttätig in eine Ausgangs- oder Ruhestellung zurückgestellt wird, wie dies anhand der Pfeile P1, P2 dargestellt ist.

Mittels des Schaummaterials 11 ist das bewegliche Sensorelement 117 im Sensormodul 10 beweglich gelagert, wobei das Schaummaterial 11 eine Verbindungs-, Rückstell- und Abdichtungsfunktion übernimmt. Optional kann das das feste Sensorelement 116 der Sensoreinheit 110 ebenfalls vom Schaummaterial 11 gekapselt sein. In diesem Ausführungsbeispiel ist das feste Sensorelement 116 Teil der Vormontageeinheit 27.

In einer Weiterbildung ist das bewegliche Sensorelement 117 als ein elastisches Auslöseelement ausgebildet. Hierdurch kann die Sensoreinheit 110 als ein manuell kraftgesteuerter Druckschalter mit Rückstellfunktion ausgebildet sein. Beispielsweise ist die Sensoreinheit 110 als ein Kraftsensor, insbesondere ein kraftgesteuerter kapazitiver oder induktiver Sensor, zum Ausführen einer Schaltfunktion ausgebildet.

Dazu ist zusätzlich ein Betätigungselement 101 vorgesehen, das beispielsweise oberhalb des beweglichen Sensorelements 117, einem elastischen Auslöseelement, angeordnet ist.

**Figuren 1 und 2** zeigen das Betätigungselement 101 als ein Stößel oder Druckknopf, der oberhalb des Schaummaterials 11 angeordnet ist. Das Betätigungselement 101 ist dabei insbesondere in Druckrichtung DR betätigbar.

Zusätzlich kann das bewegliche Sensorelement 117 als ein elektronisches Sensorelement, insbesondere eine kapazitive Sensorelektrode, mittels der Elektronikeinheit 109 geschaltet werden. Hierdurch kann die Sensoreinheit 110 nicht nur als Druckschalter, sondern zusätzlich zur Erkennung einer Annäherung eines Objekts verwendet werden und somit als Annäherungssensor dienen.

Das bewegliche Sensorelement 117 umfasst ein Basiselement 14, das vollständig oder bereichsweise von dem Schaummaterial 11 gekapselt ist. Das bewegliche Sensorelement 117 ist zumindest in Richtung des festen Sensorelements 116 mit dem Schaummaterial 11 versehen. Mit anderen Worten: Das Schaummaterial 11 ist zumindest zwischen dem beweglichen Sensorelement 117 und dem festen Sensorelement 116 angeordnet.

Das Basiselement 14 ist insbesondere als eine Auslöseplatte, insbesondere ein Federblech oder eine Blechplatte, ausgebildet. Im Ausführungsbeispiel nach **Figuren 1 und 2** sind die Anschlusselemente 12 als Steckkontakte ausgebildet und ragen aus dem Schaummaterial 11 vertikal nach unten hervor.

Zusätzlich kann die Sensoreinheit 110 von einem Vergussmaterial 15 zumindest bereichsweise umgeben sein. Insbesondere kann eine äußere Schicht um das Schaummaterial 11 herum optional mit dem Vergussmaterial 15 versehen sein. Zusätzlich kann das Sensormodul 10, insbesondere deren miteinander vormontierte elektronische Komponenten, wie zum Beispiel die Sensoreinheit 110 und die Elektronikeinheit 109, zumindest bereichsweise von dem Vergussmaterial 15 umgeben sein. Ein solches Sensormodul 10 ist als eine integrierte Baueinheit 23, insbesondere eine separate Montageeinheit 28 oder ein separates Montagemodul, ausgebildet.

Das gekapselte und integrierte Bauteil 103 mit dem beweglichen

Sensorelement 117, dem optionalen festen Sensorelement 116 und dem optionalen Betätigungselement 101 können die Vormontageeinheit 27 bilden, wie in **Figur 1** in Explosionsdarstellung gezeigt ist. Die Vormontageeinheit 27 ist dann in diesem Vormontagezustand (gekapselt) auf einer Seite der Elektronikeinheit 109 montierbar und bildet im zusammengebauten Zustand als integrierte Baueinheit 23 die separate Montageeinheit 28 des elektronischen Sensormoduls 10. Die Vormontageeinheit 27 als gekapseltes integriertes Bauteil 103 umfasst die Sensorik und optional das Betätigungselement 101. Die zugehörige Elektronikeinheit 109 ist Teil der integrierten Baueinheit 23 und damit der separaten Montageeinheit 28.

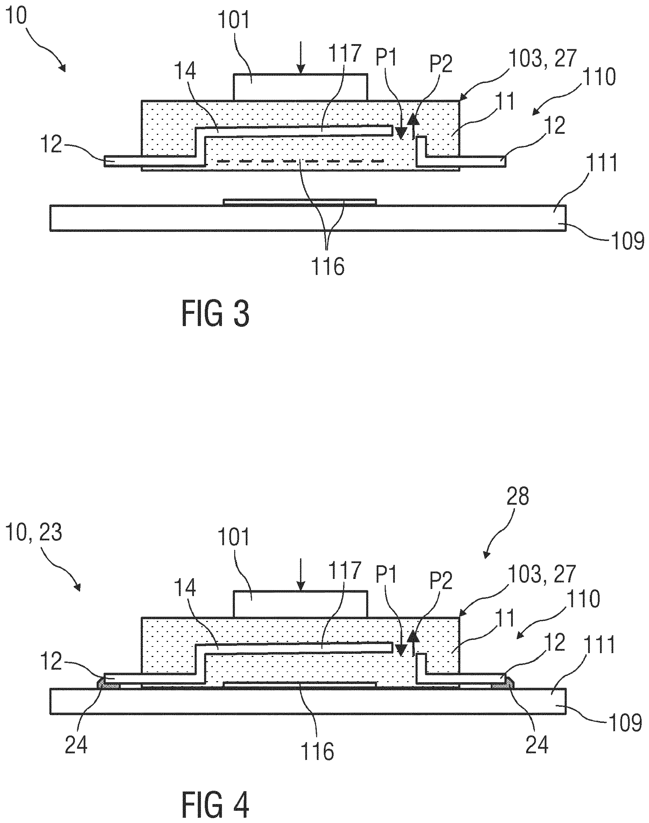

**Figuren 3 und 4** zeigen eine weitere optionale Ausführungsform des elektronischen Sensormoduls 10. Anstelle von Steckkontakten sind die Anschlusselemente 12 als Oberflächenanschlusselemente (= sogenannte SMD-Anschlüsse) des integrierten Bauteils 103, insbesondere der Vormontageeinheit 27, ausgebildet und ragen horizontal aus dem Schaummaterial 11 hervor, so dass diese Anschlusselemente 12 mit der Elektronikeinheit 109, insbesondere mit einer Leiterbahn auf der oberen Oberflächenseite der Leiterplatte 111 verbunden werden können (**Figur 3****,** Vormontagezustand) bzw. sind (**Figur 4****,** montierter Zustand). Beispielsweise sind die Anschlusselemente 12 als lötfähige Anschlussflächen 24 direkt auf die Leiterplatte 111 gelötet.

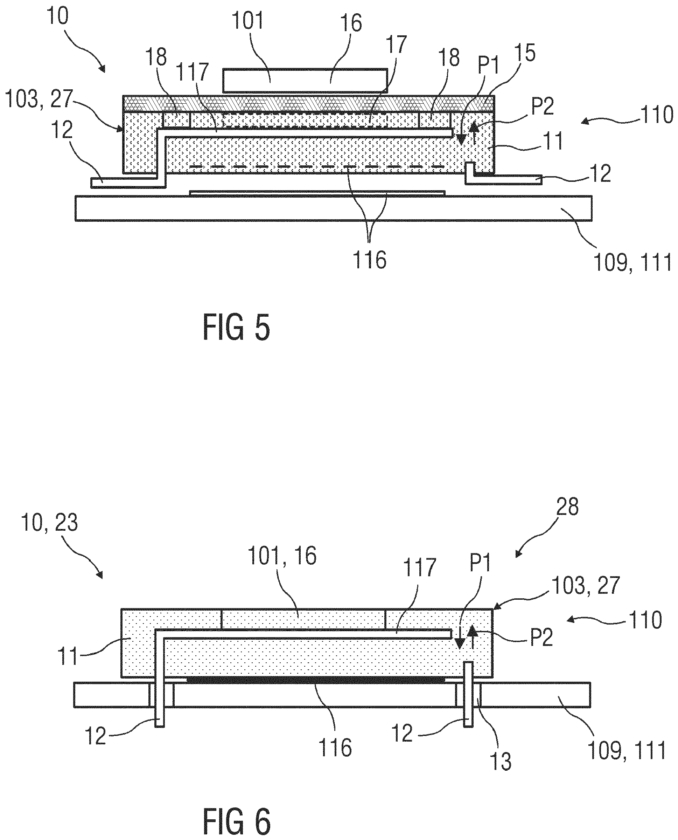

**Figur 5** zeigt eine weitere optionale Ausführungsform des elektronischen Sensormoduls 10 mit einem zumindest teilweise gekapselten Betätigungselement 101. Im Ausführungsbeispiel nach **Figur 5** ist das Betätigungselement 101 zweiteilig ausgebildet und umfasst einen Betätigungsstößel 16 und einen im Schaummaterial 11 angeordneten Gegenstößel 17. Das Betätigungselement 101 kann Teil des integrierten Bauteils 103 und damit der Vormontageeinheit 27 sein. Zusätzlich können Abstandselemente 18 vorgesehen sein, um die Betätigungsbewegung, insbesondere eine Hubbewegung, des Betätigungselements 101 zu begrenzen.

Diese Abstandselemente 18 können auch bei den anderen gezeigten Ausführungsbeispielen für das elektronische Sensormodul 10 vorgesehen sein. Die Abstandselemente 18 können als ein umlaufender Materialstrang ausgebildet sein und zusätzlich zur Stützfunktion und Anschlagsfunktion eine Dichtungsfunktion realisieren.

**Figur 6** zeigt eine weitere optionale Ausführungsform des elektronischen Sensormoduls 10 im montierten Zustand als separate Montageeinheit 28, wobei das Betätigungselement 10 als Betätigungsstößel 16 vollständig vom Schaummaterial 11 gekapselt ist und damit Teil des integrierten Bauteils 103 und der Vormontageeinheit 27 ist.

In einer weiteren, nicht näher dargestellten Option kann ein mehrteiliges Betätigungselement 101 einen Gegenstößel 17, der unterhalb des beweglichen Sensorelements 117 als Teil des integrierten Bauteils 103 ausgebildet ist, und einen Betätigungsstößel 16, der oberhalb des beweglichen Sensorelements 117 angeordnet ist, umfassen.

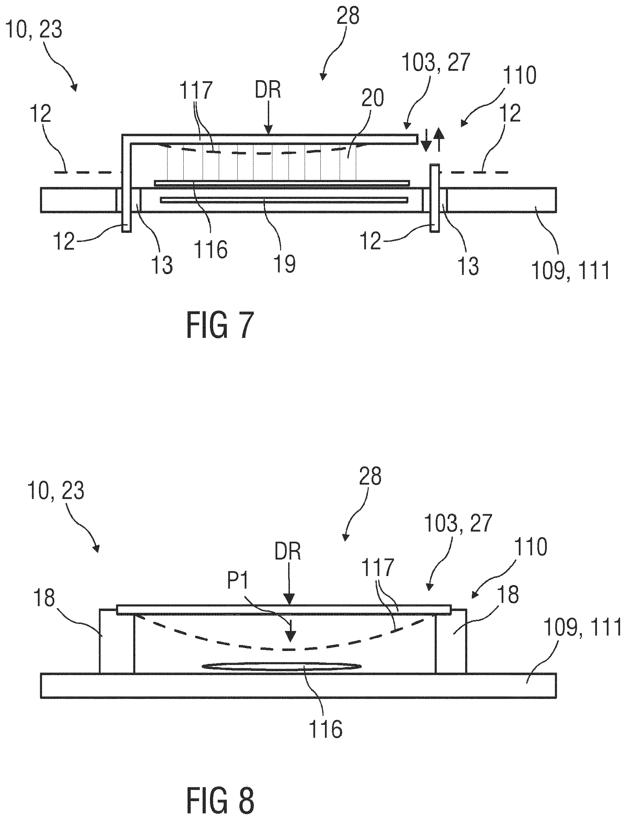

**Figur 7** zeigt die Ausbildung der Sensoreinheit 110 als kapazitiven Sensor, wobei das bewegliche Sensorelement 117 und das feste Sensorelement 116 jeweils Elektroden bilden, die voneinander beabstandet sind, so dass zwischen diesen bei aktivierter Sensoreinheit 110 ein Messfeld 20 ausgebildet ist, so dass beim Drücken des beweglichen Sensorelements 117 in Druckrichtung DR die Änderung des kapazitiven Messfeldes erfasst und zur Bestimmung des Betätigungshubes verwendet wird, um bei einem hinreichend großen Betätigungshub eine Schaltfunktion auszulösen.

Zusätzlich kann auf der vom beweglichen Sensorelement 117 abgewandten Seite des festen Sensorelements 116 eine Abschirmung 19, insbesondere als eine Metallschicht in der Leiterplatte 111, vorgesehen sein. Zur besseren Übersicht wurden das Schaummaterial 11 und das Betätigungselement 101 nicht dargestellt.
**Figur 8** zeigt die Ausbildung der Sensoreinheit 110 als induktiven Sensor, wobei das bewegliche Sensorelement 117 als eine Metallfeder oder Metallblech und das feste Sensorelement 116 als eine Spule ausgebildet sind, die voneinander beabstandet sind, so dass beim Drücken des beweglichen Sensorelements 17 in Druckrichtung DR die Änderung der Induktivität der Spule erfasst und zur Bestimmung des Betätigungshubes/der Kraft verwendet wird, um bei einer hinreichend großen Induktivitätsänderung eine Schaltfunktion auszulösen.

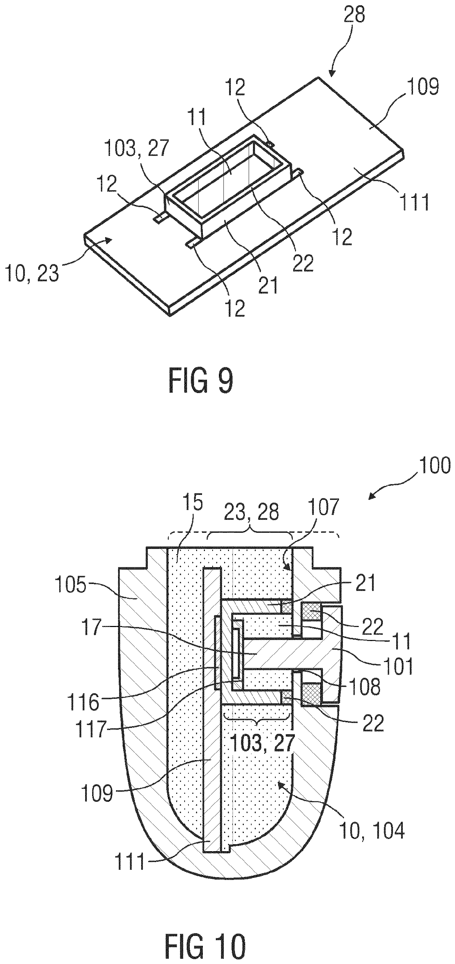

**Figur 9** zeigt das elektronische Sensormodul 10 in perspektivischer Darstellung mit der Elektronikeinheit 109 als Leiterplatte 111 im montierten Zustand als separate Montageeinheit 28 und dem integrierten Bauteil 103 als Vormontageeinheit 27, welche zumindest das Schaummaterial 11 und die darin gekapselten beweglichen Sensorelemente 117 (nicht dargestellt) umfasst. Das Schaummaterial 11 kann zusätzlich von einem Sensorgehäuse 21 umgeben sein. Das Sensorgehäuse 21 kann darüber hinaus zur zusätzlichen Abdichtung des integrierten Bauteils 103 mit einem Dichtungsstrang 22 versehen sein.

Das elektronische Sensormodul 10 kann mit allen Komponenten, der Elektronikeinheit 109 und der Sensoreinheit 110 zu der integrierten Baueinheit 23 als separate Montageeinheit 28 vormontiert sein, die als Ganzes in ein Griffmodul 100 endmontiert werden kann, das nachfolgend beispielhaft beschrieben wird.

**Figur 10** zeigt eine mögliche Ausführungsform für ein Griffmodul 100 mit einem elektronischen Sensormodul 10, das als eine integrierte Baueinheit 23 und Montageeinheit 28 im Griffmodul 100 anordbar ist, insbesondere endmontierbar ist und nach erfolgter Montage form- und/oder kraftschlüssig angeordnet ist.

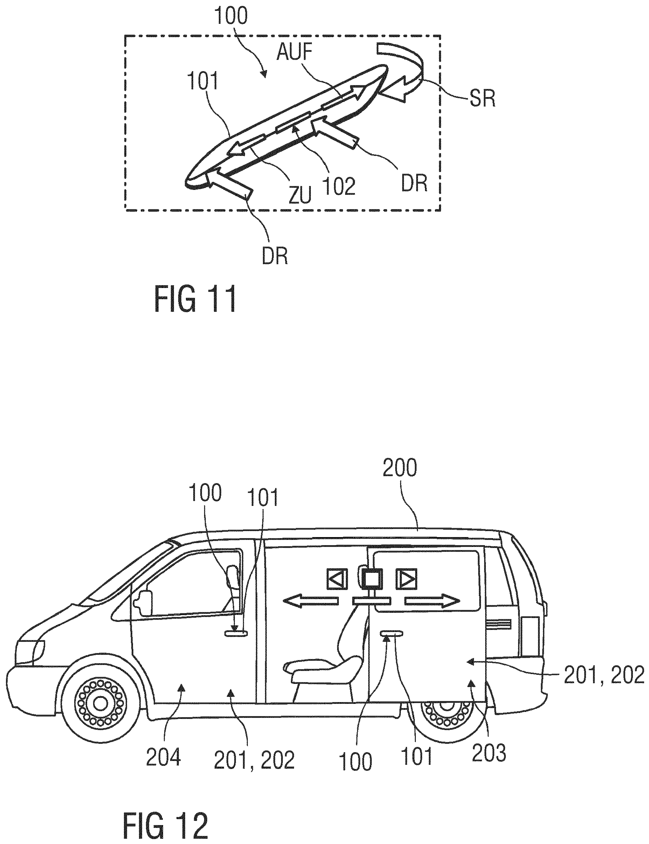

Das Griffmodul 100 ist ein Außengriffmodul für ein bewegliches Fahrzeugelement 201, insbesondere eine Fahrzeugtür 202 eines Fahrzeugs 200, wie es in den nachfolgenden **Figuren 11 bis 17** im Detail gezeigt ist.

Das Griffmodul 100 umfasst beispielsweise zumindest das elektronische Sensormodul 10 als integrierte Baueinheit 23 und einen Griffträger 105, an oder in welchem das Sensormodul 10 anordbar oder im montierten Zustand form- und/oder kraftschlüssig gehalten ist.

Das elektronische Sensormodul 10 in Form der integrierten Baueinheit 23 kann als Ganzes zu der integrierten Baueinheit 23 vormontiert und als separate Montageeinheit 28 anschließend in dem Griffmodul 100 verbaut, insbesondere endmontiert, werden. Dabei kann die integrierte Baueinheit 23 sowohl das elektronische Sensormodul 10 als auch das Betätigungselement 101, die zu der Vormontageeinheit 27 montiert sind, umfassen. Alternativ kann die integrierte Baueinheit 23 nur das elektronische Sensormodul 10 umfassen, welches separat als ein Montagemodul im Griffträger 105 montiert wird. Das Betätigungselement 101 wird als ein separates Montageelement ebenfalls im Griffträger 105 montiert.

Dabei sind durch die Ausbildung des Griffmoduls 100 mit dem innen liegenden Sensormodul 10 mit gekapselten elektronischen Komponenten diese geschützt angeordnet. Zusätzlich kann das Sensormodul 10 innerhalb des Griffmoduls 100 mittels eines Vergussmaterials 15 gekapselt sein.

In einer möglichen Ausführungsform ist das elektronische Sensormodul 10 als eine Auslöseeinheit 104 zum automatischen Auslösen einer Funktion, insbesondere zum Auslösen einer Entriegelung und eines automatischen Öffnens des Türschlosses der Fahrzeugtür 202 ausgebildet. Durch die Integration von Elektronikeinheit 109 und Sensoreinheit 110 in das elektronische Sensormodul 10 und damit in die Auslöseeinheit 104 kann das Sensormodul 10 zusätzlich zur Auslösefunktion weitere Funktionen, zum Beispiel weitere elektronische Griff-, Schloss- und/oder Türfunktionen, übernehmen und ausführen.

Das Betätigungselement 101 ist oberhalb des beweglichen Sensorelements 117 im Griffträger 105 angeordnet und umfasst den Betätigungsstößel 17, der durch die Durchgangsöffnung 108 im Griffträger 105 hindurchragt und das bewegliche Sensorelement 117 betätigt und infolgedessen mittels der Elektronikeinheit 109 ein Betätigungssignal erzeugt zum Auslösen einer Schaltfunktion für das Türschloss.

Durch die Ausbildung des Sensormoduls 10 als integrierte Baueinheit 23 im Griffmodul 100 und die zusätzliche Kapselung des Sensormoduls 10 durch den Griffträger 105 und das Betätigungselement 101 und den Dichtungssträngen 22 ist eine zusätzliche Dichtebene auf der Außenseite des Griffmoduls 100 gegeben, so dass der Betätigungs-, insbesondere ein Hubmechanismus, des Betätigungselements 101 ebenfalls abgedichtet ist.

Das integrierte Bauteil 23 des Sensormoduls 10 ist im Griffträger 105 an einer Innenseite 107 des Griffträgers 105 im Bereich der Durchgangsöffnung 108 und gegenüberliegend zum Betätigungselement 101 angeordnet und montiert. Dies ermöglicht einen kompakten Aufbau des Griffmoduls und kleine Betätigungshübe.

**Figur 11** zeigt schematisch in Draufsicht ein Griffmodul 100 mit einem Betätigungselement 101 mit einer äußeren Betätigungsfläche 102. Das Betätigungselement 101 ist dabei insbesondere in Druckrichtung DR betätigbar.

Zusätzlich oder optional kann das Betätigungselement 101 in Schwenkrichtung SR betätigbar sein.

Optional kann das Griffmodul 100 ausgebildet sein, eine Gestensteuerung für eine Schließrichtung ZU und eine Öffnungsrichtung AUF zu erkennen.

**Figur 12** zeigt schematisch in Seitenansicht ein Fahrzeug 200 mit zwei beweglichen Fahrzeugelementen 201. Das bewegliche Fahrzeugelement 201 ist beispielsweise eine Fahrzeugtür 202, insbesondere eine Schiebetür 203 oder eine Schwenktür 204. Das Fahrzeugelement 201 umfasst das Griffmodul 100 zur Entriegelung eines Türschlosses und zum Öffnen des Fahrzeugelements 201.

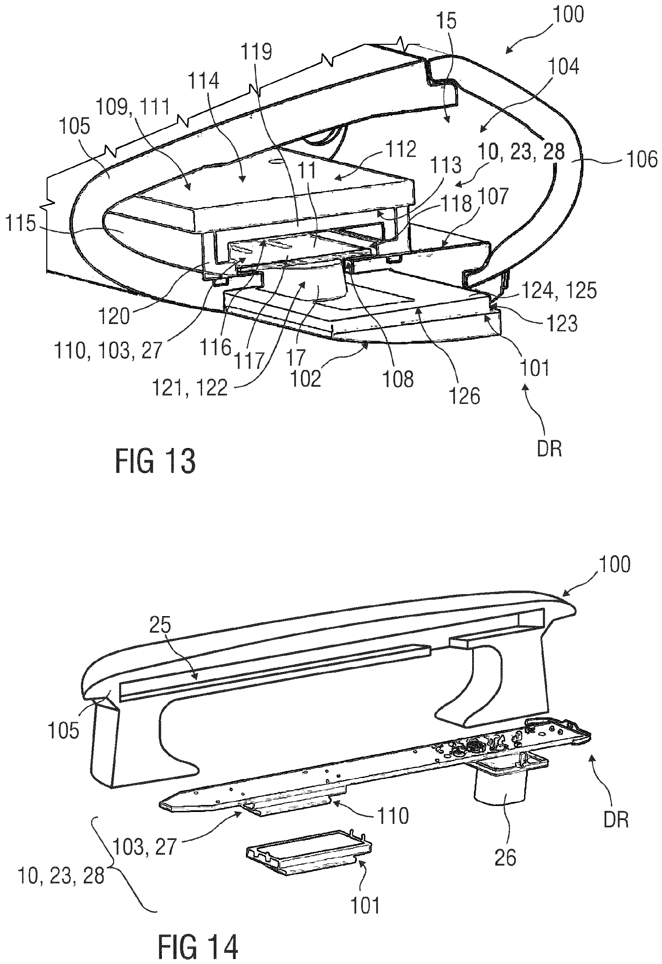

**Figuren 13 und 14** zeigen schematisch in perspektivischer Teilansicht beziehungsweise in Explosionsdarstellung das Griffmodul 100 mit dem elektronischen Sensormodul 10 als integrierte Baueinheit 23 und Auslöseeinheit 104 und mit dem integrierten Modul 103, welches zumindest das gekapselte bewegliche Sensorelement 117 umfasst.

Das Griffmodul 100 ist als ein Türaußengriffmodul ausgebildet und umfasst das Betätigungselement 101 mit der äußeren Betätigungsfläche 102. Das Griffmodul 100 umfasst darüber hinaus den Griffträger 105, an welchem das Betätigungselement 101 gehalten ist. Die Auslöseeinheit 104 ist zur automatischen Entriegelung und zum automatischen Öffnen eines Türschlosses der zugehörigen Fahrzeugtür 202 vorgesehen. Die Auslöseeinheit 104 ist als ein integriertes Bauteil 103 ausgebildet und vormontiert im Griffträger 105 angeordnet.

Zusätzlich umfasst das Griffmodul 100 eine Griffblende 106, zum Beispiel eine Chrom- oder Kunststoffblende.

Die Auslöseeinheit 104 als integriertes Bauteil 103 kann als Ganzes in dem Griffmodul 100 verbaut werden. Bedingt durch die Ausbildung der Auslöseeinheit 104 als ein integriertes Modul entfallen aufwendige einzelne Montageschritte.

**Figur 14** zeigt eine Explosionsdarstellung des Griffmoduls 100, das als ein Griffelement ausgebildet ist, und des Sensormoduls 10.

Der Griffträger 105 und die Blende 106 umgeben dabei zumindest teilweise das Sensormodul 10, das als Ganzes als integrierte Baueinheit 23 in das Griffmodul 100 eingebaut und montiert werden kann. Dazu umfasst das Griffmodul 100 beispielsweise im Griffträger 105 eine Ausnehmung 25, in welche das Sensormodul 10 als vormontierte integrierte Baueinheit 23 einsteckbar oder einschiebbar ist und dort form- und/oder kraftschlüssig gehalten ist. Dabei sind beispielsweise die Sensoreinheit 110, die Elektronikeinheit 109, das Betätigungselement 101 und/oder optional ein Mikroschalter 26 auf der Elektronikeinheit 109 vormontiert und bilden im montierten Zustand die integrierte Baueinheit 23, die dann in die Ausnehmung 25, insbesondere einen Schlitz oder eine Öffnung, eingeführt wird und in der Ausnehmung 25 beispielsweise form- und/oder kraftschlüssig, beispielsweise mittels Reibschluss oder rastend, gehalten ist.

Die Griffblende 106 ist zum Beispiel eine Chrom- oder Kunststoffblende.

Darüber hinaus kann durch die Ausbildung des Griffmoduls 100 mit dem äußeren Betätigungselement 101 ein elektrisches Türschloss sicher durch Druckbetätigung ausgelöst werden, wobei die innen liegenden elektronischen Komponenten der Auslöseeinheit 104 geschützt angeordnet sind. Hierzu ist die Auslöseeinheit 104 beispielsweise durch Kapselung, insbesondere zusätzlich mittels eines Vergussmaterials 15, geschützt.

Beispielsweise umgeben der Griffträger 105 und das Betätigungselement 101 die Auslöseeinheit 104 kapselnd. Durch die Ausbildung der Auslöseeinheit 104 als integriertes Modul 104 und die zusätzliche Kapselung dieses durch den Griffträger 105 und das Betätigungselement 101 ist eine zusätzliche Dichtebene auf der Außenseite des Griffmoduls 100 gegeben, so dass der Betätigungs-, insbesondere ein Hubmechanismus, des Betätigungselements 101 ebenfalls abgedichtet ist.

Das integrierte Bauteil 103 ist im Griffträger 105 an der Innenseite 107 des Griffträgers 105 im Bereich der Durchgangsöffnung 108 und gegenüberliegend zum Betätigungselement 101 angeordnet und montiert. Dies ermöglicht einen kompakten Aufbau des Griffmoduls 100 und kleine Betätigungshübe.

Die Auslöseeinheit 104 umfasst im Detail beispielsweise eine Elektronikeinheit 109 und eine Sensoreinheit 110, die zu dem integrierten Bauteil 103 vormontiert sind.

Durch die Integration der Elektronikeinheit 109 und der Sensoreinheit 110 in die Auslöseeinheit 104 des Sensormoduls 10 kann diese weitere Funktionen, zum Beispiel weitere elektronische Griff-, Schloss- und/oder Türfunktionen, übernehmen und ausführen.

Die Elektronikeinheit 109 umfasst die Leiterplatte 111 mit einer ersten Oberflächenseite 112 und einer zweiten Oberflächenseite 113. Auf der ersten Oberflächenseite 112 ist eine integrierte Schaltungsanordnung 114, zum Beispiel eine Multi-Funktionselektronik für ein oder mehrere Funktionen, insbesondere für ein oder mehrere elektronische Griff-, Schloss- und/oder Türfunktionen, angeordnet. Auf der gegenüberliegenden zweiten Oberflächenseite 113 ist die Sensoreinheit 110 angeordnet.

Die Sensoreinheit 110 ist beispielsweise als ein Kraftsensor, insbesondere ein kraftgesteuerter kapazitiver Sensor, zum Entriegeln und Öffnen des Türschlosses und der Fahrzeugtür 202 ausgebildet.

Insbesondere ist die Sensoreinheit 110 als ein sogenanntes MOC-Modul ausgebildet (= metall-over-cap-Modul), bei welchem die innen liegenden metallischen Sensorkomponenten nach außen hin gekapselt sind.

Die Sensoreinheit 110 umfasst darüber hinaus das Sensorgehäuse 115, das feste Sensorelement 116 und das bewegliche Sensorelement 117.

Das feste Sensorelement 116 ist direkt auf der zweiten Oberflächenseite 113 der Leiterplatte 111 angeordnet. Das bewegliche Sensorelement 117 ist im Abstand zum festen Sensorelement 116 in einer Aufnahmeöffnung 118 des Sensorgehäuses 115 angeordnet. Das Sensorgehäuse 115 und das bewegliche Sensorelement 117 kapseln dabei das innen liegende feste Sensorelement 116 nach außen hin ab. Das Sensorgehäuse 115 ist insbesondere ein Kunststoffgehäuse und kann an die Leiterplatte 111 angeformt, insbesondere angespritzt sein. Das Sensorgehäuse 115 kann als ein 2-Komponenten-Gehäuse ausgebildet sein. Beispielsweise kann das Sensorgehäuse 115 eine innenliegende weiche Gehäusewand 119 und eine diese umgebende äußere harte Gehäusewand 120 aufweisen.

Im eingebauten Zustand des integrierten Bauteils 103 im Griffmodul 100 ist das bewegliche Sensorelement 117 im Bereich der Durchgangsöffnung 108 derart angeordnet, dass es die Durchgangsöffnung 108 von innen zumindest teilweise überdeckt.

Das Betätigungselement 101 ist derart im Bereich der Durchgangsöffnung 108 angeordnet, dass es die Durchgangsöffnung 108 von außen zumindest teilweise überdeckt. Insbesondere ragt das Betätigungselement 101 derart in die Durchgangsöffnung 108 zumindest bereichsweise hinein, dass es in einer unbetätigten Stellung, wie in **Figur 13** gezeigt, zum beweglichen Sensorelement 117 beabstandet angeordnet ist.

Dies ermöglicht einen kompakten Aufbau des Griffmoduls 100 und kleine Betätigungshübe. Darüber hinaus sind die Betätigungskräfte einstellbar, insbesondere sind Schwellenwerte vorgebbar. Beispielsweise können Schwellenwerte für den Betätigungshub vorgegeben werden, so dass ein Entriegeln des Türschlosses nur ausgelöst wird, wenn der Betätigungshub den vorgegebenen Schwellenwert überschritten hat. Bei Unterschreiten eines Schwellenwertes für den Betätigungshub erfolgt hingegen keine Entriegelung des Türschlosses. Auch können die Schwellenwerte für den Betätigungshub in Abhängigkeit von erfassten Werten weiterer Parameter, wie zum Beispiel Luftfeuchtigkeit, Temperatur, Geschwindigkeit des Fahrzeugs, etc. variieren und somit entsprechend dynamisch angepasst werden. Hierzu umfasst die Elektronikeinheit 109 entsprechende Filter, Softwarelogiken und/oder Analysemodule. Darüber hinaus ermöglicht die Kapselung mittels des Schaummaterials 11 und die Abdichtung mittels der Dichtungsstränge 22 Toleranzkompensationen, insbesondere die Kompensation von Fertigungstoleranzen zur Kalibrierung der Sensoreinheit 110.

Darüber hinaus kann das Betätigungselement 101 ein Druckübertragungselement 121 umfassen, dass von der äußeren Betätigungsfläche 102 nach innen in Richtung der Sensoreinheit 110 ragt. Beispielsweise umfasst das Betätigungselement 101 einen Betätigungsstößel 16, zum Beispiel einen nach innen ragenden Druckstift 122, welcher bei Betätigung des Betätigungselements 101 in Druckrichtung DR und damit in Richtung des beweglichen Sensorelements 117 bewegbar ist.

Dabei ist das Betätigungselement 101 derart durch Druck betätigbar, dass es in Druckrichtung DR durch die Durchgangsöffnung 108 hindurch bis zum beweglichen Sensorelement 117 bewegbar ist und dieses bei weiterer Druckbetätigung in Richtung des festen Sensorelements 116 bewegt. Hierdurch wird der Abstand zwischen dem beweglichen Sensorelement 117 und dem festen Sensorelement 116 reduziert, so dass sich das zwischen diesen vorhandenes Messfeld 20 ändert.

Zur Erfassung dieser Messfeldänderung ist die Sensoreinheit 110 als ein kapazitiver Drucksensor ausgebildet, wobei das feste Sensorelement 116 und das bewegliche Sensorelement 117 als Elektroden ausgebildet sind, die mit einer elektronischen Schalteinheit der Elektronikeinheit 109 auf der Rückseite (= erste Oberflächenseite 112) der Leiterplatte 111 signaltechnisch gekoppelt ist. Wird mittels der elektronischen Schalteinheit eine Messfeldänderung aufgrund der Druckbetätigung erfasst, wird das Türschloss automatisch geöffnet.

Das bewegliche Sensorelement 117 ist hierzu beispielsweise als eine Blattfeder, eine Federplatte oder ein Federblech ausgebildet.

Ferner weist das Betätigungselement 101 eine der äußeren Betätigungsfläche 102 gegenüberliegende Innenseite 123 auf, die mittels eines Verbindungselements 124 mit dem Griffträger 105 zumindest im Bereich der Durchgangsöffnung 108 abdichtend verbunden ist. Mit anderen Worten: Das Betätigungselement 101 ist mittels des Verbindungselements 124 mit dem Griffträger 105 verbunden, insbesondere verklebt.

Dabei kann das Verbindungselement 124 zusätzlich als ein Rückstellelement 125 ausgebildet sein, das bei einer Betätigung des Betätigungselements 101 von einer unbetätigten Position in eine betätigte Position dieses bei Nichtbetätigung zurück in die unbetätigte Position stellt.

Hierzu ist das Verbindungselement 124 beispielsweise als ein Kunststoffstrang, insbesondere ein Gummi- oder Schaumstrang, ausgebildet. Insbesondere ist das Verbindungselement 124 aus einem Weichkomponentenmaterial, insbesondere aus einem Schaum-, Kunststoff- oder Gummimaterial gebildet. Beispielsweise ist das Verbindungselement 124 aus einem PUR-Schaum, insbesondere einen CeraPur-Schaum gebildet.

Das Verbindungselement 124 kann auf der der Sensoreinheit 110 zugewandten Innenseite 123 des Betätigungselements 101 darüber hinaus einen im Randbereich der Durchgangsöffnung 108 angeordneten umlaufenden Dichtungsstrang 126 bilden.

Alternativ oder zusätzlich kann das Verbindungselement 124 das Betätigungselement 101 auf der der Sensoreinheit 110 zugewandten Innenseite 123 randseitig umlaufen und gegen Feuchtigkeit und Verschmutzung abdichten.

Somit übernimmt das Verbindungselement 124 mehrere Funktionen: zumindest Abdichtung, Befestigung und Zurückstellung. Darüber hinaus kann das Verbindungselement 124 zur Dämpfung von Vibrationen dienen.

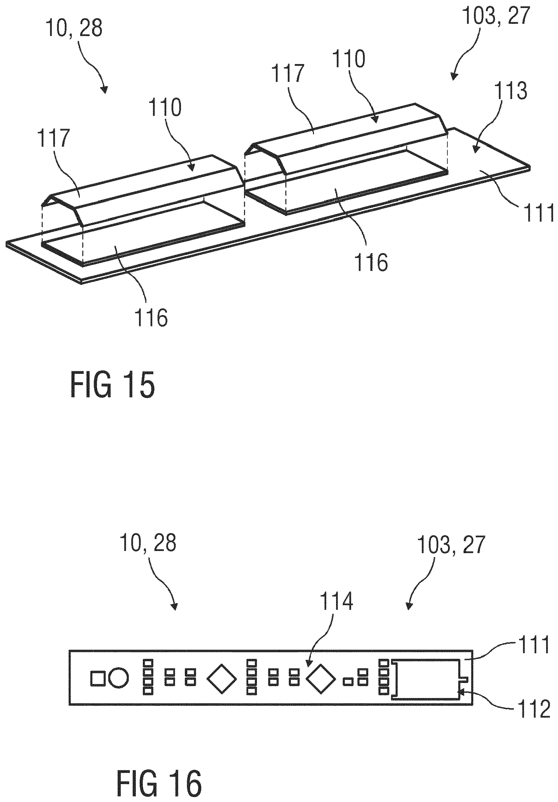

**Figuren 15 und 16** zeigen schematisch eine Ober- und Unterseite des integrierten Bauteils 103 für das Griffmodul 100. Das integrierte Bauteil 103 umfasst die Leiterplatte 111 mit der ersten Oberflächenseite 112 und der zweiten Oberflächenseite 113. Auf der ersten Oberflächenseite 112 ist die integrierte Schaltungsanordnung 114, zum Beispiel eine Multi-Funktionselektronik für ein oder mehrere Funktionen, insbesondere für ein oder mehrere elektronische Griff-, Schloss- und/oder Türfunktionen, angeordnet. Auf der gegenüberliegenden zweiten Oberflächenseite 113 ist die Sensoreinheit 110, insbesondere deren festes Sensorelement 116 und das zu diesem beabstandete bewegliche Sensorelement 117 angeordnet und vormontiert.

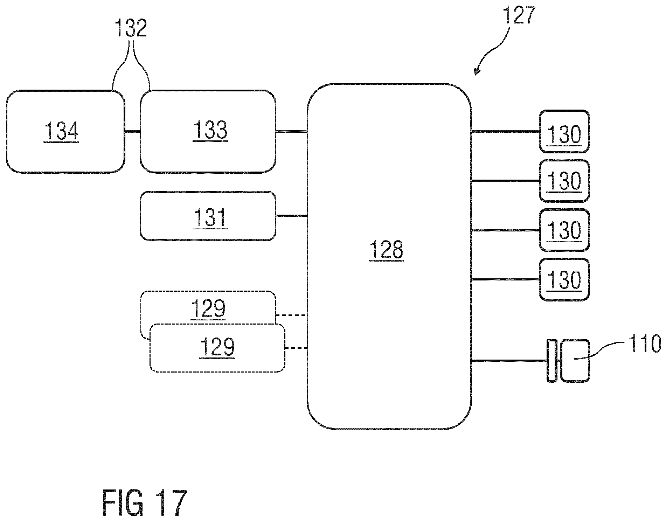

**Figur 17** zeigt schematisch in Blockdarstellung Komponenten des integrierten Bauteils 103, insbesondere die Komponenten einer elektronischen Schaltung 127 für die Sensoreinheit 110. Die elektronische Schaltung 127 ist Teil der integrierten Schaltungsanordnung 114 der Leiterplatte 111 und umfasst beispielsweise einen Mikrocontroller 128. Der Mikrocontroller 128 umfasst eine Softwarelogik, mittels welcher die von der Sensoreinheit 110 erfasste Messfeldänderung analysiert und entsprechend das Türschloss entriegelt und somit öffnet.

Ferner kann die Softwarelogik des Mikrocontrollers 128 ausgebildet sein, dass bei Bewegung der entriegelten Fahrzeugtür 202 die Bewegung der Fahrzeugtür 202 an jeder Position gestoppt werden kann, wenn eine Messfeldänderung aufgrund eines erneuten Drückens des Betätigungselements 101 identifiziert wird.

Somit ermöglicht die Auslöseeinheit 104 gekoppelt mit der integrierten Schaltungsanordnung 114 sowohl eine Entriegelung und damit ein Öffnen des Türschlosses durch Drücken des Betätigungselements 101 als auch ein Stoppen der sich bewegenden Fahrzeugtür 202 an jeder gewünschten Position durch erneutes Drücken des Betätigungselements 101.

Der Mikrocontroller 128 kann weitere Softwarefunktionen für das Türschloss, die Fahrzeugtür 202 und/oder das Griffmodul 100 umfassen. Hierzu ist der Mikrocontroller 128 beispielsweise über ein oder mehrere Kommunikationsschnittstellen 129, zum Beispiel eine LIN-Schnittstelle oder eine CAN-Schnittstelle, mit anderen Komponenten gekoppelt. Ferner können weitere, im Griffmodul 100 optional implementierte Sensoren 130, zum Beispiel weitere kapazitive Sensoren zur Gestenerkennung und/oder Annäherungserkennung, mit dem Mikrocontroller 128 signaltechnisch gekoppelt sein.

Ferner kann der Mikrocontroller 128 über weitere Eingangs- und Ausgangsschnittstellen 131 mit anderen elektronischen Komponenten oder externen, mobilen Geräten, wie einem Mobiltelefon, signaltechnisch gekoppelt sein.

Darüber hinaus kann der Mikrocontroller 128 mit weiteren Softwaremodulen 132, zum Beispiel einem Spannungsregler 133 und/oder einer EMV-Schutzeinrichtung 134, signaltechnisch gekoppelt sein.

Im Mikrocontroller 128 können darüber hinaus zur Identifizierung einer Betätigung des Betätigungselements 101 Schwellwertmodule, Filtermodule, Regenmodule, Störungsmodule, Zeitmodule, Geschwindigkeitsmodule implementiert sein, welche beispielsweise in Abhängigkeit von Temperatur, Regen, EMV-Störungen, Betätigungsgeschwindigkeit und/oder Luftfeuchtigkeit Schwellwertanpassungen zur Identifizierung einer Messfeldänderung dynamisch vornehmen, um eine Druckbetätigung des Betätigungselements 101 sicher und schnell zu ermitteln.

So wird beispielsweise bei einem starken Signalhub in einer schnellen Auslösezeit keine relevante Betätigung und somit kein Auslösesignal zum Entriegeln des Türschlosses erzeugt.

Bei einer langsamen Betätigungsgeschwindigkeit wird ein Auslösesignal zum Entriegeln erzeugt, wenn die Signalhöhe den vorgegebenen Schwellwert überschreitet.

Beispielsweise wird als Schwellwert für einen Betätigungshub ein Wert von 2 mm vorgegeben.

### BEZUGSZEICHENLISTE

- 10: Sensormodul
- 11: Schaummaterial
- 12: Anschlusselement
- 13: Durchgangsöffnung
- 14: Basiselement
- 15: Vergussmaterial
- 16: Betätigungsstößel
- 17: Gegenstößel
- 18: Abstandselement
- 19: Abschirmung
- 20: Messfeld
- 21: Sensorgehäuse
- 22: Dichtungsstrang
- 23: integrierte Baueinheit
- 24: Anschlussfläche
- 25: Ausnehmung
- 26: Mikroschalter
- 27: Vormontageeinheit
- 28: Montageeinheit

- 100: Griffmodul
- 101: Betätigungselement
- 102: Betätigungsfläche
- 103: integriertes Bauteil
- 104: Auslöseeinheit
- 105: Griffträger
- 106: Blende
- 107: Innenseite
- 108: Durchgangsöffnung
- 109: Elektronikeinheit
- 110: Sensoreinheit
- 111: Leiterplatte
- 112: erste Oberflächenseite
- 113: zweite Oberflächenseite
- 114: integrierte Schaltungsanordnung
- 115: Sensorgehäuse
- 116: festes Sensorelement
- 117: bewegliches Sensorelement
- 118: Aufnahmeöffnung
- 119: weiche Gehäusewand
- 120: harte Gehäusewand
- 121: Druckübertragungselement
- 122: Druckstift
- 123: Innenseite
- 124: Verbindungselement
- 125: Rückstellelement
- 126: Dichtungsstrang
- 127: elektronische Schaltung
- 128: Mikrocontroller
- 129: Kommunikationsschnittstelle
- 130: Sensor
- 131: Eingangs- und Ausgangsschnittstelle
- 132: Softwaremodul
- 133: Spannungsregler
- 134: EMV-Schutzeinrichtung
- 200: Fahrzeug
- 201: bewegliches Fahrzeugelement
- 202: Fahrzeugtür
- 203: Schiebetür
- 204: Schwenktür

- AUF: Öffnungsrichtung
- DR: Druckrichtung
- P1, P2: Pfeil
- SR: Schwenkrichtung
- ZU: Schließrichtung

## Patentansprüche

1. Elektronisches Sensormodul (10), insbesondere für einen Griff, umfassend zumindest:
- eine Sensoreinheit (110) mit
einem beweglichen Sensorelement (117) und
einem festen Sensorelement (116), welches beabstandet und gegenüberliegend zu dem beweglichen Sensorelement (117) angeordnet ist, und
- eine Elektronikeinheit (109), die elektrisch mit den Sensorelementen (116, 117) zum Auslösen eines Schaltsignals verbunden ist und auf der das feste Sensorelement (116) angeordnet ist,
wobei zumindest das bewegliche Sensorelement (117) mittels eines Schaummaterials (11) zumindest bereichsweise gekapselt ist und als ein integriertes Bauteil (103) in Form einer Vormontageeinheit (27) ausgebildet ist, wobei Anschlusselemente (12) des beweglichen Sensorelements (117) aus dem Schaummaterial (11) in einem Vormontagezustand herausragen und in einem montierten Zustand mit der Elektronikeinheit (109) verbunden sind.

2. Elektronisches Sensormodul (10) nach Anspruch 1,
wobei im montierten Zustand der Vormontageeinheit (27) mit der Elektronikeinheit (109) das elektronische Sensormodul (10) als eine integrierte Baueinheit (23) und eine separate Montageeinheit (28) ausgebildet ist.

3. Elektronisches Sensormodul (10) nach Anspruch 1 oder 2,
wobei das bewegliche Sensorelement (117) ein Basiselement (14) umfasst, das vollständig oder bereichsweise von dem Schaummaterial (11) gekapselt ist und Teil der Vormontageeinheit (27) ist.

4. Elektronisches Sensormodul (10) nach einem der vorhergehenden Ansprüche, wobei die Sensoreinheit (110) zusätzlich von einem Vergussmaterial (15) zumindest bereichsweise umgeben ist.

5. Elektronisches Sensormodul (10) nach einem der vorhergehenden Ansprüche, wobei die Sensoreinheit (110) als ein Kraftsensor zum Ausführen einer Schaltfunktion ausgebildet ist.

6. Elektronisches Sensormodul (10) nach einem der vorhergehenden Ansprüche, wobei zur Betätigung des beweglichen Sensorelements (117) ein Betätigungselement (101) vorgesehen ist, das oberhalb und/oder unterhalb des beweglichen Sensorelements (117)angeordnet ist.

7. Elektronisches Sensormodul (10) nach Anspruch 6,
wobei das Betätigungselement (101) bereichsweise oder vollständig von dem Schaummaterial (11) gekapselt ist und Teil des integrierten Bauteils (103) und der Vormontageeinheit (27) ist.

8. Griffmodul (100), insbesondere ein Außengriffmodul für ein bewegliches Fahrzeugelement (201) eines Fahrzeugs (200), wobei das Griffmodul (100) ein elektronisches Sensormodul (10) nach einem der vorhergehenden Ansprüche und einen Griffträger (105) umfasst, an oder in welchem das elektronische Sensormodul (10) anordbar ist.

9. Griffmodul (100) nach Anspruch 8, wobei das elektronische Sensormodul (10) als eine Auslöseeinheit (104) zum automatischen Auslösen einer Funktion, insbesondere zum Auslösen einer Entriegelung und eines automatischen Öffnens eines Türschlosses der Tür, ausgebildet ist.

10. Griffmodul (100) nach Anspruch 8 oder 9, wobei bei einer Anordnung eines Betätigungselements (101) oberhalb eines beweglichen Sensorelements (117) im elektronischen Sensormodul (10) der Griffträger (105) und das Betätigungselement (101) die Auslöseeinheit (104) kapselnd umgeben.

11. Griffmodul (100) nach Anspruch 10, wobei das integrierte Bauteil (103) im Griffträger (105) an einer Innenseite (107) des Griffträgers (105) im Bereich einer Durchgangsöffnung (108) und gegenüberliegend zum Betätigungselement (101) angeordnet und montiert ist.

12. Griffmodul (100) nach einem der Ansprüche 9 bis 11, wobei die Elektronikeinheit (109) eine Leiterplatte (111) mit einer ersten Oberflächenseite (112) und einer zweiten Oberflächenseite (113) umfasst, wobei auf der ersten Oberflächenseite (112) eine integrierte Schaltungsanordnung (114) und auf der gegenüberliegenden zweiten Oberflächenseite (113) die Sensoreinheit (110) angeordnet ist.

13. Griffmodul (100) nach einem der vorhergehenden Ansprüche 9 bis 12, wobei die Sensoreinheit (110) zusätzlich ein Sensorgehäuse (115) umfasst, wobei das feste Sensorelement (116) direkt auf der zweiten Oberflächenseite (113) der Leiterplatte (111) angeordnet ist und das bewegliche Sensorelement (117) im Abstand zum festen Sensorelement (116) in einer Aufnahmeöffnung (118) des Sensorgehäuses (115) angeordnet ist.

14. Bewegliches Fahrzeugelement (201) mit einem Griffmodul (100) nach einem der vorhergehenden Ansprüche 8 bis 13, in oder an welchem ein Sensormodul (10) nach einem der Ansprüche 1 bis 7 anordbar oder angeordnet ist.
